# EUROPEAN PATENT APPLICATION

(11) **EP 4 557 612 A1**
(43) Date of publication of application: **21.05.2025**
(21) Application number: 24208707.0
(22) Date of filing: 24.10.2024
(51) Int. Cl.: H03F 3/72

(54) **SWITCHABLE TRANSCONDUCTANCE AMPLIFIER**

(30) Priority: 17.11.2023 US 202318512765
(71) Applicant: Nokia Solutions and Networks Oy, 02610 Espoo (FI)
(72) Inventor: THOMAS, Philipp, Garwood, 07027 (US)
(74) Representative: Nokia EPO representatives

(57) **Abstract**

A basic (single-ended or differential) switchable transconductance amplifier has voltage-input circuitry and selector circuitry connected between capacitor circuitry and current-sink circuitry, where the capacitor circuitry and the selector circuitry are controlled to selectively convert an input voltage signal applied to the voltage-input circuitry into an output current signal, where the voltage-input circuitry and the selector circuitry are implemented at the same circuit level. More-complex circuits, such as multiplexers and de-multiplexers, can be based on the basic amplifier circuitry. By implementing the voltage-input circuitry and the selector circuitry at the same circuit level, the resulting circuit can have lower voltage overhead than equivalent prior-art circuitry, resulting in shorter switching time, higher operational bandwidth, and lower power consumption.

## Description

### BACKGROUND

### Field of the Disclosure

The present disclosure relates to electronic circuitry and, more specifically but not exclusively, to transconductance amplifiers that convert an input voltage into an output current.

### Description of the Related Art

This section introduces aspects that may help facilitate a better understanding of the disclosure. Accordingly, the statements of this section are to be read in this light and are not to be understood as admissions about what is prior art or what is not prior art.

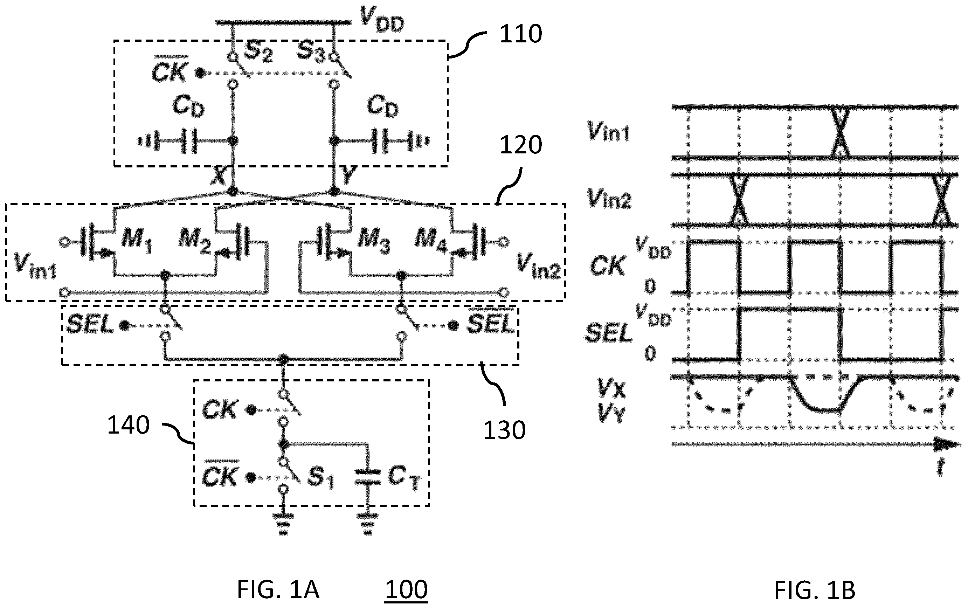

FIG. 1A is a schematic circuit diagram of a conventional 2:1 analog multiplexer (AMUX) 100 of the prior art, and FIG. 1B is a signal timing diagram for the AMUX 100 of FIG. 1A. See Y. Chang et al., "An 80-Gb/s 44-mW Wireline PAM4 Transmitter," IEEE Journal of Solid-State Circuits, vol. 53, no. 8, pp. 2214-2226, Aug. 2018, the teachings of which are incorporated herein by reference. As shown in FIG. 1A, AMUX 100 comprises a circuit stack consisting of capacitor circuitry 110 on top of voltage-input circuitry 120 on top of selector circuitry 130 on top of current-sink circuitry 140.

The inverted clock signal *C̅K̅* is applied to control the switches S₂ and S₃ of the capacitor circuitry 110. The differential input voltage signal Vᵢₙ₁ is applied to the gates of transistors M₁ and M₂ and the differential input voltage signal Vᵢₙ₂ is applied to the gates of transistors M₃ and M₄ of the voltage-input circuitry 120. The selection signal SEL and the inverted selection signal *S̅E̅L̅* are respectively applied to control the switches S₄ and S₅ of the selector circuitry 130. The clock signal CK and the inverted clock signal *C̅K̅* are respectively applied to control the switches S₀ and S₁ of the current-sink circuitry 140. As indicated in FIG. 1B, the frequency of the selection signal SEL is half the frequency of the clock signal CK, and the frequencies of the input voltages Vᵢₙ₁ and Vᵢₙ₂ are half the frequency of the selection signal SEL. Furthermore, the input voltages Vᵢₙ₁ and Vᵢₙ₂ are offset from one another by one clock cycle.

In operation, the AMUX 100 functions as a switchable transconductance amplifier that multiplexes the two differential, input voltage signals Vᵢₙ₁ and Vᵢₙ₂ to form a single, multiplexed, differential, output current signal across nodes X and Y.

### SUMMARY

The voltage overhead required by the circuit stack of the prior-art AMUX 100 of FIG. 1A may result in undesirably high power consumption, long switching times, and low operational bandwidth. Problems in the prior art are addressed in accordance with the principles of the present disclosure by switchable transconductance amplifier circuitry having voltage-input circuitry and selector circuitry at the same circuit level between capacitor circuitry and current-sink circuitry. The resulting amplifier can have lower voltage overhead than equivalent prior-art circuitry, resulting in shorter switching time, higher operational bandwidth, and lower power consumption.

### BRIEF DESCRIPTION OF THE DRAWINGS

Embodiments of the disclosure will become more fully apparent from the following detailed description, the appended claims, and the accompanying drawings in which like reference numerals identify similar or identical elements.
FIG. 1A is a schematic circuit diagram of a conventional analog multiplexer (AMUX) of the prior art, and FIG. 1B is a timing diagram for the AMUX of FIG. 1A.
FIG. 2A is a schematic circuit diagram of a switchable transconductance amplifier according to certain embodiments of the present disclosure;
FIG. 2B is a signal timing diagram for one possible way of operating the amplifier of FIG. 2A with a hold phase;
FIG. 2C is a signal timing diagram for one possible way of operating the amplifier of FIG. 2A without a hold phase;
FIG. 2D is a signal timing diagram for one possible way of operating the amplifier of FIG. 2A with the reset signal RESET always at +1;
FIGs. 3-6 are schematic circuit diagrams of switchable transconductance amplifiers according to alternative embodiments of the present disclosure;
FIG. 7 is a schematic circuitry diagram of a single-ended, switchable transconductance amplifier according to certain embodiments of the present disclosure;
FIG. 8A is a schematic circuit diagram of a 2:1 AMUX according to certain embodiments of the present disclosure;
FIG. 8B is a signal timing diagram for one possible way of operating the AMUX of FIG. 8A without a hold phase;
FIGs. 9 and 10 are schematic circuit diagrams of 2:1 AMUXs according to alternative embodiments of the present disclosure;
FIG. 11A is a schematic circuit diagram of a 1:2 analog demultiplexer (ADEMUX) according to certain embodiments of the present disclosure; and
FIG. 11B is a signal timing diagram for one possible way of operating the ADEMUX of FIG. 11A with a hold phase.

### DETAILED DESCRIPTION

Detailed illustrative embodiments of the present disclosure are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of example embodiments of the disclosure.

As used herein, the singular forms "a," "an," and "the," are intended to include the plural forms as well, unless the context clearly indicates otherwise. It further will be understood that the terms "comprises," "comprising," "contains," "containing," "includes," and/or "including," specify the presence of stated features, steps, or components, but do not preclude the presence or addition of one or more other features, steps, or components. It also should be noted that in some alternative implementations, the functions/acts noted may occur out of the order noted in the figures. For example, two figures shown in succession may in fact be executed substantially concurrently or may sometimes be executed in the reverse order, depending upon the functions/acts involved.

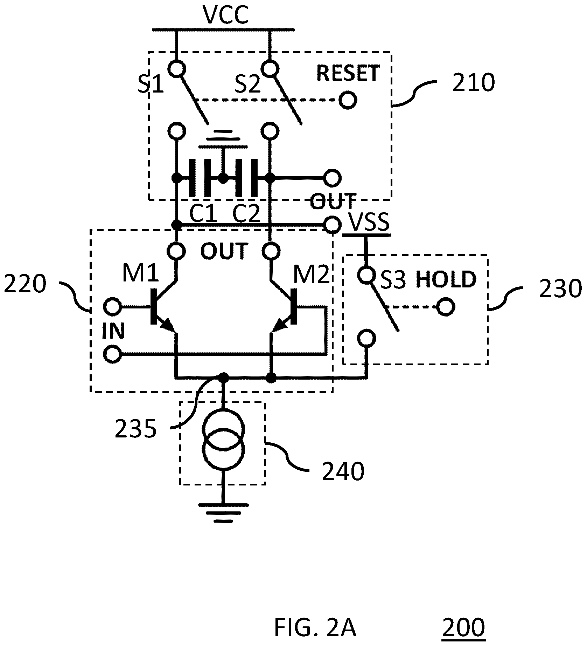

FIG. 2A is a schematic circuit diagram of a switchable transconductance amplifier 200 according to certain embodiments of the present disclosure. As shown in FIG. 2A, amplifier 200 has a circuit stack consisting of voltage-input circuitry 220 and selector circuitry 230 located between capacitor circuitry 210 and current-sink circuitry 240, where the voltage-input circuitry 220 and the selector circuitry 230 are at the same circuit level. As used herein, the term "same circuit level" implies that the circuits share the voltage node at which signal current steering occurs. In the amplifier 200, the voltage node at which signal current steering occurs is the node 235, which is shared by the voltage-input circuitry 220 and the selector circuitry 230. Note that, depending on the implementation, the voltage supply VSS for the selector circuitry 230 may be the same or different from (e.g., less than) the voltage supply VCC for the capacitor circuitry.

Although the current-sink circuitry 240 of FIG. 2A is shown as a constant-current sink, those skilled in the art will understand that other suitable circuitry, such as (without limitation) the clocked current-sink circuitry 140 of FIG. 1A, can be used to implement the current-sink circuitry 240.

Note that the circuitry of FIG. 2A is implemented using bipolar transistor devices. Those skilled in the art will understand that the circuitry can also be implemented using other technology, such as (without limitation) with field-effect transistor (FET) technology.

As shown in FIG. 2A, the reset signal RESET is applied to control the switches S1 and S2 of the capacitor circuitry 210, the differential input voltage IN is applied to the base terminals of transistors M1 and M2 of the voltage-input circuitry 220, and the selection signal HOLD is applied to control switch S3 of the selector circuitry 230. In operation, the amplifier 200 converts the differential voltage input signal IN into a differential current output signal OUT.

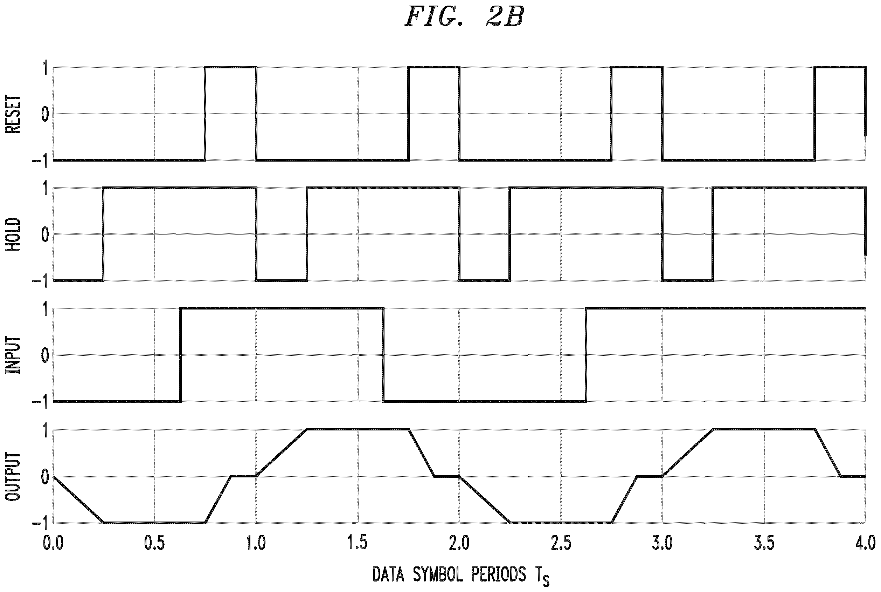

FIG. 2B is a signal timing diagram for one possible way of operating the amplifier 200 of FIG. 2A with a hold phase, where time is measured in data symbol periods T_{S}. As shown in FIG. 2B, at time t=0.0, the reset, hold, and input signals (i.e., RESET, HOLD, and IN, respectively, in FIG. 2A) are all -1, and the output (current) signal (i.e., OUT in FIG. 2A) is at 0. With RESET at -1, the switches S1 and S2 will be open (i.e., off). With HOLD at -1, switch S3 will also be open. With IN at -1, transistor M1 will be off and transistor M2 will be on. As a result, from t=0.0 to t=0.25T_{S}, current flowing through M2 and the current-sink circuitry 240, will remove charge from capacitor C2 and drive OUT towards -1.

At t=0.25Ts, HOLD goes to +1, which closes (i.e., turns on) S3, such that OUT is held at -1. At t=0.625Ts, IN goes to +1, which turns M1 on and M2 off. At t=0.75Ts, RESET goes to 1, which closes switches S1 and S2. As a result, from t=0.75Ts to t=1.0Ts, OUT rises from -1 to 0 and stays at 0. Those skilled in the art will understand that the circuit dimensions can be chosen such that the reset to 0 occurs faster or slower than depicted in Fig. 2B, but will generally take place while RESET and HOLD are at +1.

At t=1.0Ts, RESET and HOLD both go to -1, which opens S1, S2, and S3. As a result, with IN at +1, from t=1.0Ts to t=1.25Ts, OUT is driven to +1. At t=1.25Ts, HOLD goes to +1, which again closes S3 and holds OUT at +1. At t=1.625Ts, IN goes back to -1, which turns M2 off and M1 on again. At t=1.75Ts, RESET goes to +1, which closes S1 and S2. As a result, OUT is driven to 0 and stays at 0.

At t=2.0T_{S}, RESET and HOLD again both go to -1, which opens S1, S2, and S3. As a result, with IN at -1, from t=2.0T_{S} to t=2.25Ts, OUT is driven to -1. At t=2.25Ts, HOLD goes to +1, which again closes S3 and holds OUT at -1. At this point, the entire cycle is repeated.

As shown in FIG. 2B, the output current signal OUT tracks the input voltage signal IN.

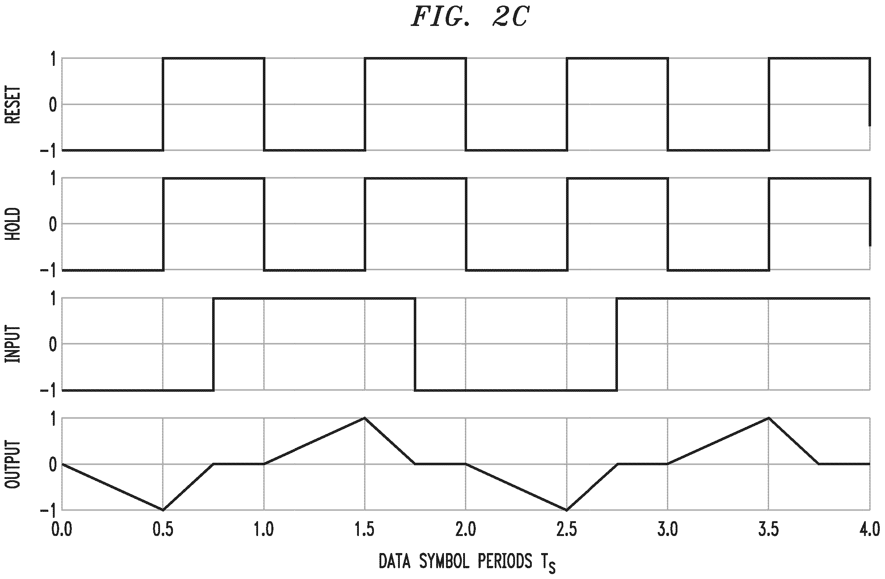

FIG. 2C is a signal timing diagram for one possible way of operating the amplifier 200 of FIG. 2A without a hold phase, where the hold signal HOLD is identical to the reset signal RESET. As a result, from t=0.0 to t=0.5Ts, with RESET and HOLD both at -1 and IN at -1, OUT is driven to -1. At t=0.5Ts, RESET and HOLD go to +1, and, from t=0.5Ts to t=0.75Ts, with IN still at -1, OUT goes to 0.

At t=0.75Ts, IN goes to +1. At t=1.0Ts, RESET and HOLD go to -1. As a result, with IN still at +1, OUT goes to +1. At t=1.5Ts, RESET and HOLD go to +1. As a result, with IN still at +1, OUT goes to 0. At t=1.75Ts, IN goes to -1 and, at t=2.0Ts, RESET and HOLD go to -1, which starts the whole cycle over again.

As shown in FIG. 2C, as in FIG. 2B, the current output signal OUT tracks the voltage input signal IN, but with less delay due to the absence of a separate hold phase.

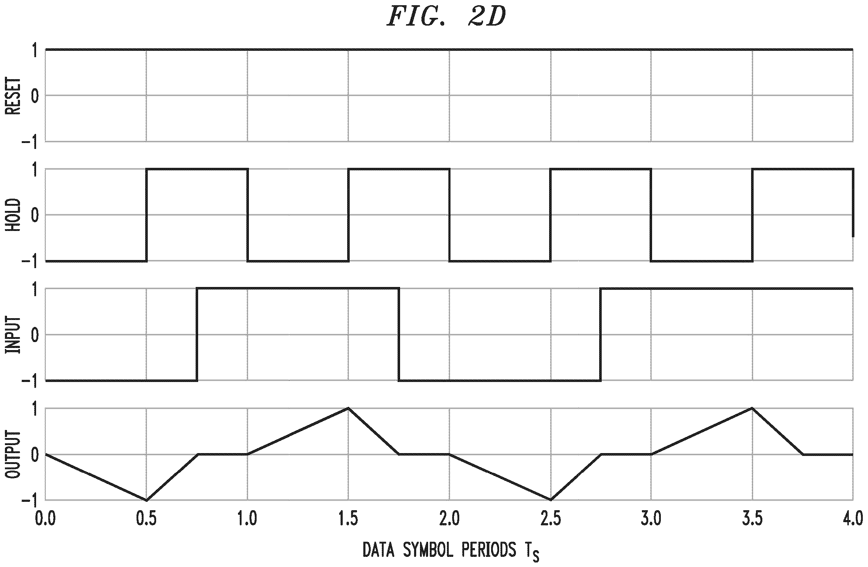

FIG. 2D is a signal timing diagram for one possible way of operating the amplifier 200 of FIG. 2A with the reset signal RESET always at +1 (and therefore with switches S1 and S2 always closed), but with the hold signal HOLD and the input signal IN the same as in FIG. 2C. As shown in FIG. 2D, the output signal OUT is identical to the output signal OUT in FIG. 2C.

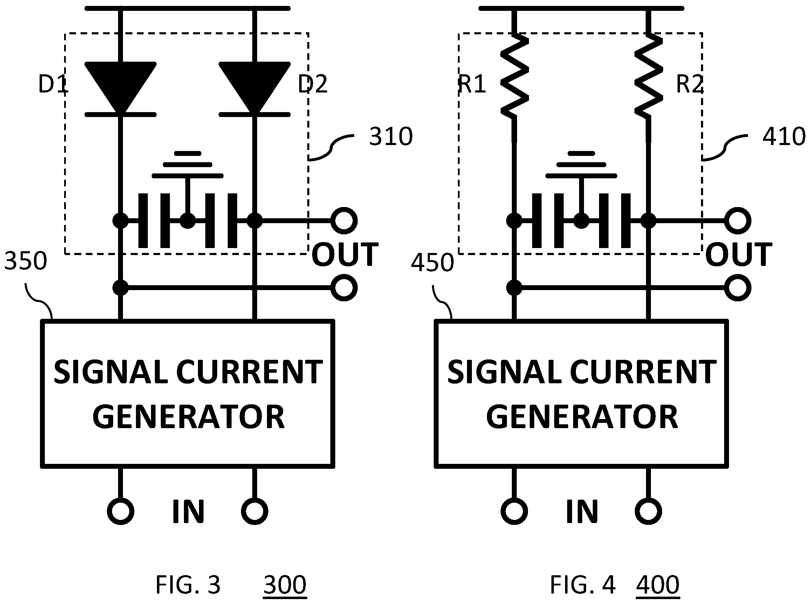

FIGs. 3 and 4 are schematic circuit diagrams of switchable transconductance amplifiers 300 and 400, respectively, according to alternative embodiments of the present disclosure, where the signal current generator 350/450 in each of FIGs. 3 and 4 represents the combination of the voltage-input circuitry 220, the selector circuitry 230, and the current-sink circuitry 240 of FIG. 2A. In particular, amplifiers 300 and 400 are equivalent to the amplifier 200 of FIG. 2A where the reset signal RESET is always at +1. In these embodiments, the pull-up diodes D1 and D2 of the capacitor circuitry 310 of FIG. 3 and the pull-up resistors R1 and R2 of the capacitor circuitry 410 of FIG. 4 are used to implement the reset signal when the signal current is off. Those skilled in the art will understand that inductive peaking can be used to speed up the reset process.

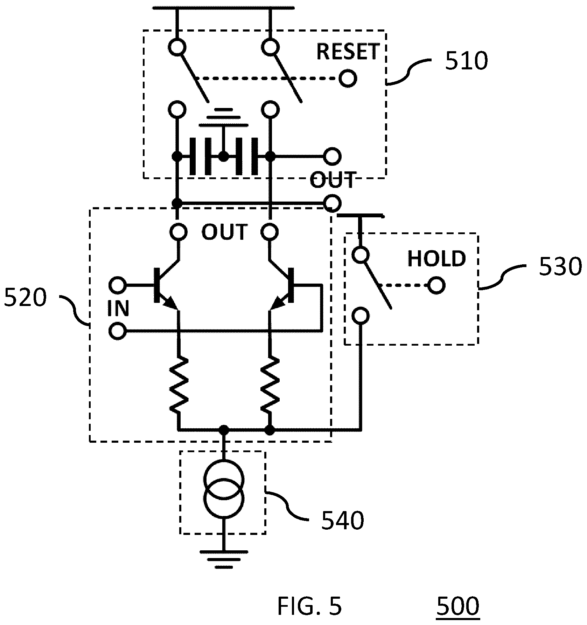

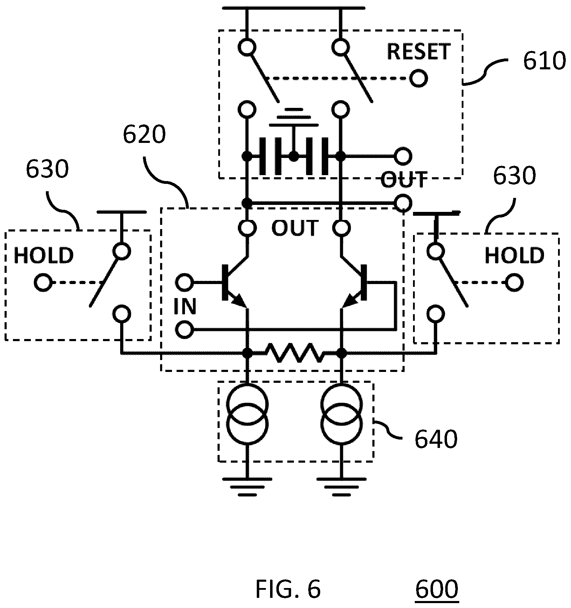

FIGs. 5 and 6 are schematic circuit diagrams of switchable transconductance amplifiers 500 and 600, respectively, according to alternative embodiments of the present disclosure. The circuitries of amplifiers 500 and 600 are analogous to the circuitry of amplifier 200 of FIG. 2A, with corresponding circuits having similar labels. Those skilled in the art will understand that the embodiments of FIGs. 5 and 6 implement two different linearization techniques and that other linearization techniques are also possible.

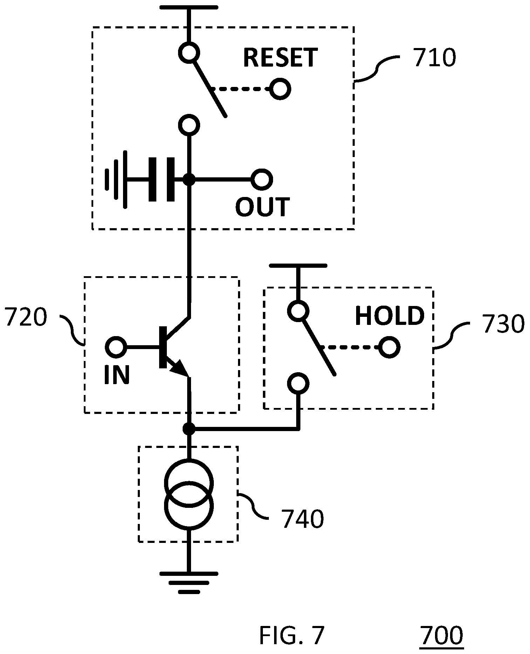

FIG. 7 is a schematic circuitry diagram of a single-ended, switchable transconductance amplifier 700 according to certain embodiments of the present disclosure. The circuitry of amplifier 700 is analogous to the circuitry of amplifier 200 of FIG. 2A, with corresponding circuits having similar labels.

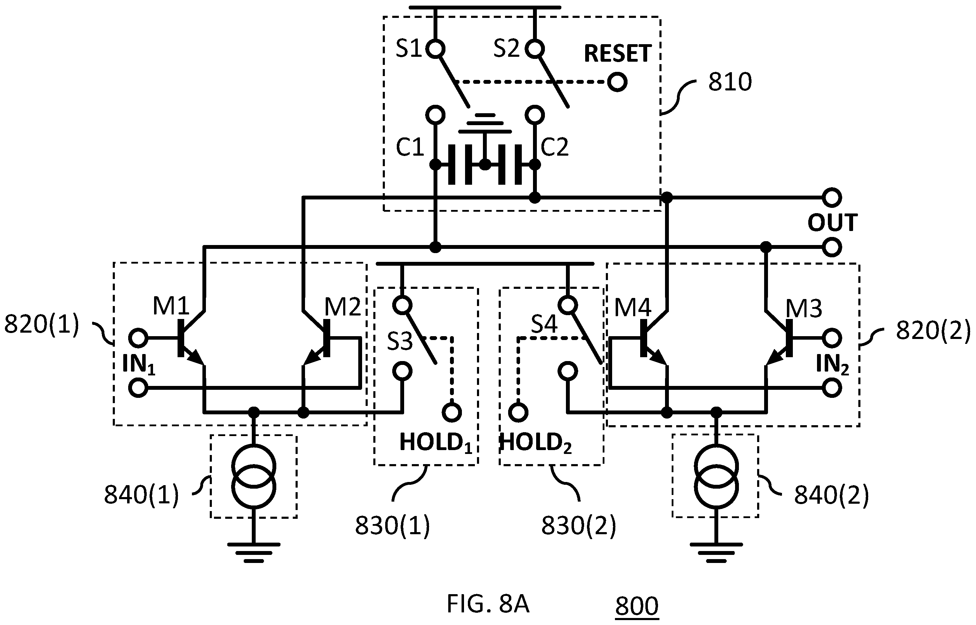

FIG. 8A is a schematic circuit diagram of a 2:1 analog multiplexer (AMUX) 800 according to certain embodiments of the present disclosure. The AMUX 800 is based on the switchable transconductance amplifier 200 of FIG. 2A, with the AMUX 800 having (i) a voltage-input circuit 820(i), a selector circuit 830(i), and a current-sink circuit 840(i) for each of the two differential input voltage signals IN₁ and IN₂ and (ii) a single, shared capacitor circuit 810. In operation, the 2:1 AMUX 800 multiplexes the differential input voltage signals IN₁ and IN₂ to generate a multiplexed differential output current signal OUT.

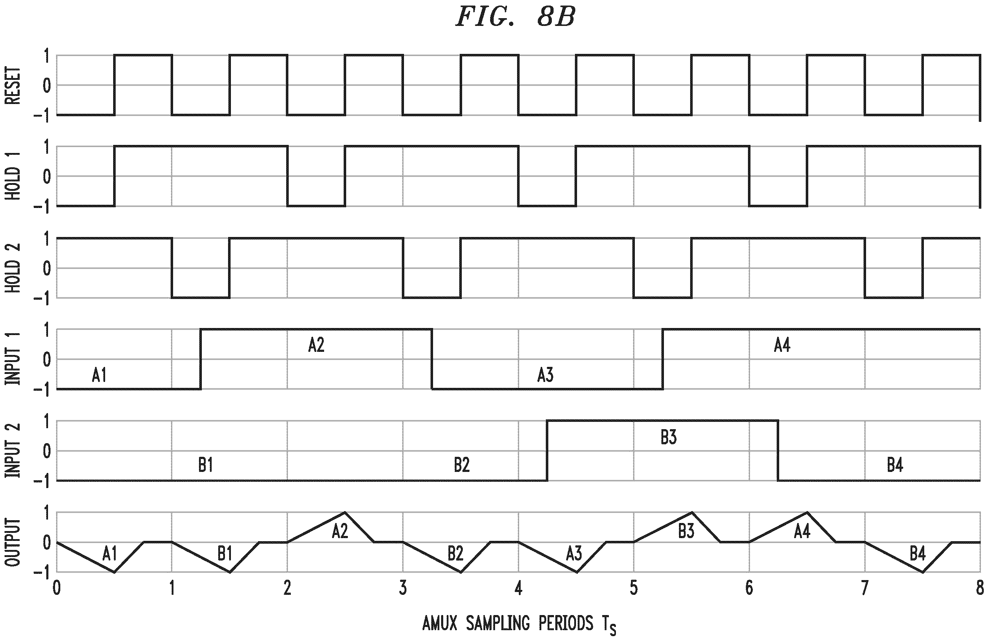

FIG. 8B is a signal timing diagram for one possible way of operating the AMUX 800 of FIG. 8A without a hold phase. With the reset signal RESET and two hold signals HOLD, and HOLD₂ shown in FIG. 8B, the output current signal OUT contains two interleaved current signals corresponding to the two input voltage signals IN₁ and IN₂. In particular, symbols A1, A2, A3, A4 of input voltage signal IN₁ and symbols B1, B2, B3, B4 of input voltage signal IN₂ appear as interleaved symbols A1, B1, A2, B2, A3, B3, A4, B4 in output current signal OUT.

As with the switchable transconductance amplifier 200 of FIG. 2A, the AMUX 800 of FIG. 8A can be equivalently operated with the reset signal RESET constantly at +1.

Those skilled in the art will understand that the architecture of 2:1 AMUX 800 of FIG. 8A can be extended to implement an N:1 AMUX, where N is any suitable integer greater than 2.

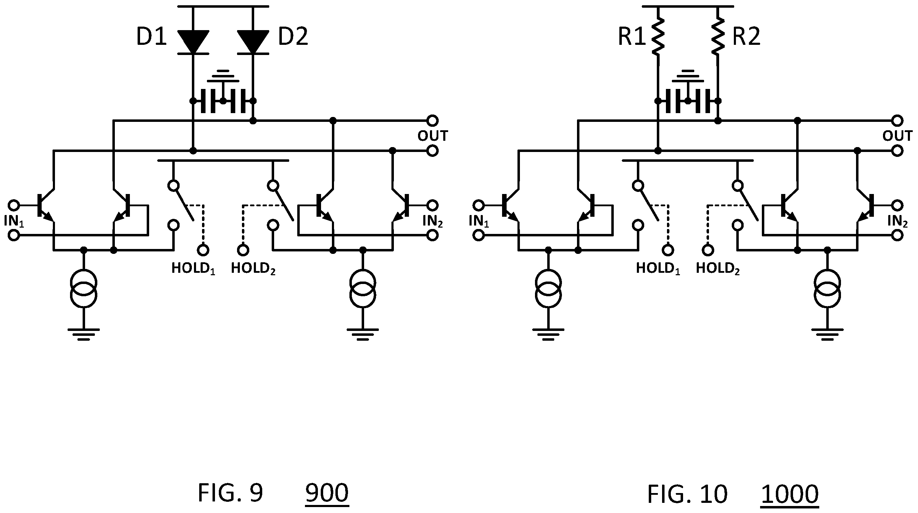

FIGs. 9 and 10 are schematic circuit diagrams of 2:1 AMUXs 900 and 1000, respectively, according to alternative embodiments of the present disclosure. In particular, AMUXs 900 and 1000 are equivalent to the AMUX 800 of FIG. 8A where the reset signal RESET is always at +1. As in the embodiments of FIGs. 3 and 4, in the embodiments of FIGs. 9 and 10, the pull-up diodes D1 and D2 of FIG. 9 and the pull-up resistors R1 and R2 of FIG. 10 are used to implement the reset signal when the signal current is off.

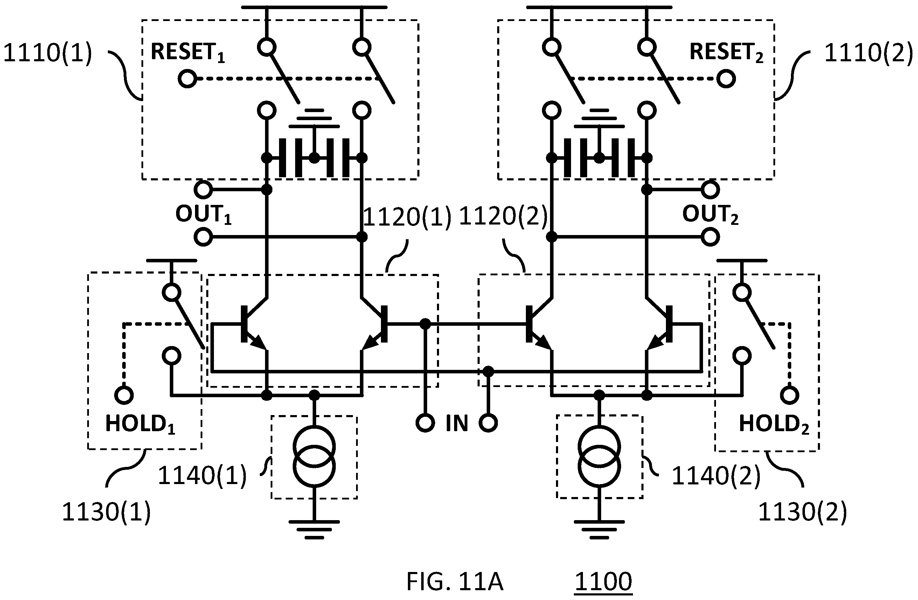

FIG. 11A is a schematic circuit diagram of a 1:2 analog demultiplexer (ADEMUX) 1100 according to certain embodiments of the present disclosure. The ADEMUX 1100 is based on the switchable transconductance amplifier 200 of FIG. 2A, with the ADEMUX 1100 having a capacitor circuit 1110(i), a voltage-input circuit 1120(i), a selector circuit 1130(i), and a current-sink circuit 1140(i) for each of the two differential output current signals OUT₁ and OUT₂. In operation, the 1:2 ADEMUX 1100 demultiplexes a differential input voltage signal IN to generate the two demultiplexed differential output current signals OUT₁ and OUT₂.

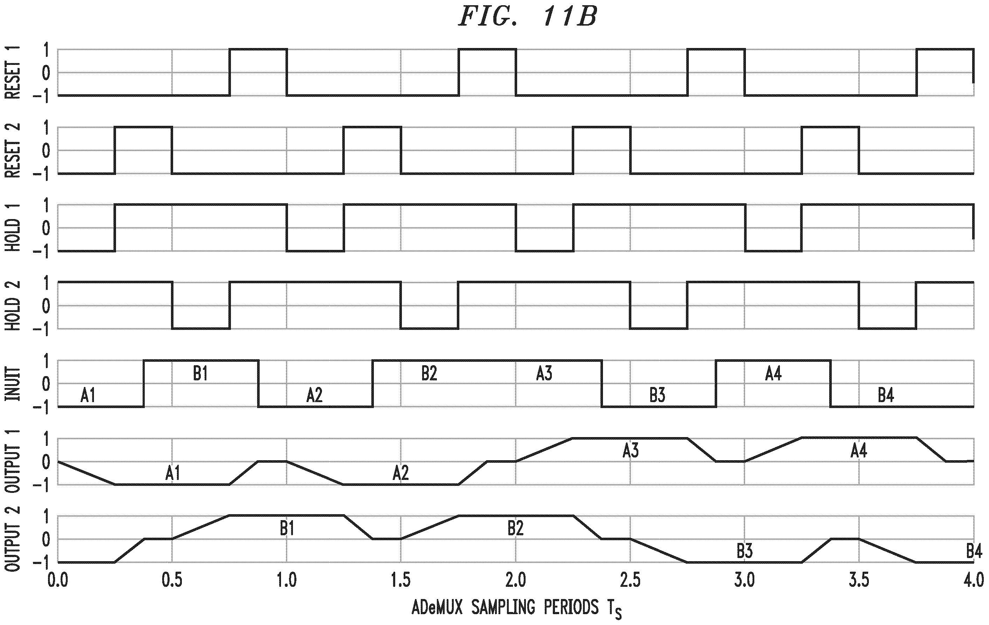

FIG. 11B is a signal timing diagram for one possible way of operating the ADEMUX 1100 of FIG. 11A with a hold phase. With the two reset signals RESET, and RESET₂ and the two hold signals HOLD, and HOLD₂ shown in FIG. 11B, the output current signals OUT₁ and OUT₂ contain de-interleaved currents signals corresponding to the input voltage signal IN. In particular, symbols A1, B1, A2, B2, A3, B3, A4, B4 of input voltage signal IN appear as de-interleaved symbols A1, A2, A3, A4 in output current signal OUT, and de-interleaved symbols B1, B2, B3, B4 in output current signal OUT₂.

As with the switchable transconductance amplifier 200 of FIG. 2A and the AMUX 800 of FIG. 8A, the ADEMUX 1100 of FIG. 11A can be equivalently operated with both of the reset signals RESET, and RESET₂ constantly at +1.

Those skilled in the art will understand that the architecture of 1:2 ADEMUX 1100 of FIG. 11A can be extended to implement a 1:N ADEMUX, where N is any suitable integer greater than 2.

Although the present disclosure has been described in the context of basic switchable transconductance amplifier circuits, such as those of FIGs. 2A and 3-6, as well as more-complex circuits that are based on those basic amplifier circuits, such as the AMUX circuits of FIGs. 8A, 9, and 10 and the ADEMUX circuit of FIG. 11A, those skilled in the art will understand that other, more-complex circuits may be based on the basic amplifier circuits. This includes any suitable circuitry that benefits from a switchable signal current, especially but not exclusively when already using clocked signals, such as selector circuitry (e.g., AMUX/ADeMUX) or logic circuitry, but also variable gain amplifiers, as well as any circuitry that benefits from the charge accumulation on the load capacitors instead of using load resistors, e.g., for increasing operation frequencies and/or decreasing operating currents.

In certain embodiments of the present disclosure, an article of manufacture comprises a switchable transconductance amplifier comprising capacitor circuitry, voltage-input circuitry, selector circuitry, and current-sink circuitry. The voltage-input circuitry and the selector circuitry are connected between the capacitor circuitry and the current-sink circuitry, the capacitor circuitry and the selector circuitry are configured to be controlled to selectively convert an input voltage signal applied to the voltage-input circuitry into an output current signal, and the voltage-input circuitry and the selector circuitry are implemented at the same circuit level.

In at least some of the above embodiments, the voltage-input circuitry is configured to receive at least one differential input voltage signal, and the amplifier is configured to generate at least one differential output current signal.

In at least some of the above embodiments, the amplifier is an N:1 multiplexer configured to receive N differential input voltage signals and generate one differential output current signal.

In at least some of the above embodiments, the amplifier comprises a single instance of the capacitor circuitry and, for each of the N differential input voltage signals, a single instance of the voltage-input circuitry, a single instance of the selector circuitry, and a single instance of the current-sink circuitry, wherein the N instances of the voltage-input circuitry and the N instances of the selector circuitry are all at the same circuit level.

In at least some of the above embodiments, the amplifier is a 1:N demultiplexer configured to receive one differential input voltage signal and generate N differential output current signals.

In at least some of the above embodiments, the amplifier comprises, for each of the N differential output current signals, a single instance of the capacitor circuitry, a single instance of the voltage-input circuitry, a single instance of the selector circuitry, and a single instance of the current-sink circuitry, wherein the N instances of the voltage-input circuitry and the N instances of the selector circuitry are all at the same circuit level.

In at least some of the above embodiments, the capacitor circuitry comprises a pair of capacitors connected to a pair of reset switches.

In at least some of the above embodiments, for each differential input voltage, the voltage-input circuitry comprises a pair of input transistors, and the selector circuitry comprises a single selection switch.

In at least some of the above embodiments, the current-sink circuitry comprises a constant-current sink.

Unless explicitly stated otherwise, each numerical value and range should be interpreted as being approximate as if the word "about" or "approximately" preceded the value or range.

The use of figure numbers and/or figure reference labels in the claims is intended to identify one or more possible embodiments of the claimed subject matter in order to facilitate the interpretation of the claims. Such use is not to be construed as necessarily limiting the scope of those claims to the embodiments shown in the corresponding figures.

Although the elements in the following method claims, if any, are recited in a particular sequence with corresponding labeling, unless the claim recitations otherwise imply a particular sequence for implementing some or all of those elements, those elements are not necessarily intended to be limited to being implemented in that particular sequence. Likewise, additional steps may be included in such methods, and certain steps may be omitted or combined, in methods consistent with various embodiments of the disclosure.

Reference herein to "one embodiment" or "an embodiment" means that a particular feature, structure, or characteristic described in connection with the embodiment can be included in at least one embodiment of the disclosure. The appearances of the phrase "in one embodiment" in various places in the specification are not necessarily all referring to the same embodiment, nor are separate or alternative embodiments necessarily mutually exclusive of other embodiments. The same applies to the term "implementation."

Unless otherwise specified herein, the use of the ordinal adjectives "first," "second," "third," etc., to refer to an object of a plurality of like objects merely indicates that different instances of such like objects are being referred to, and is not intended to imply that the like objects so referred-to have to be in a corresponding order or sequence, either temporally, spatially, in ranking, or in any other manner.

Also for purposes of this description, the terms "couple," "coupling," "coupled," "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements. The same type of distinction applies to the use of terms "attached" and "directly attached," as applied to a description of a physical structure. For example, a relatively thin layer of adhesive or other suitable binder can be used to implement such "direct attachment" of the two corresponding components in such physical structure.

The described embodiments are to be considered in all respects as only illustrative and not restrictive. In particular, the scope of the disclosure is indicated by the appended claims rather than by the description and figures herein. All changes that come within the meaning and range of equivalency of the claims are to be embraced within their scope.

For purposes of this disclosure, it is understood that all gates are powered from a fixed-voltage power domain (or domains) and ground unless shown otherwise. Accordingly, all digital signals generally have voltages that range from approximately ground potential to that of one of the power domains and transition (slew) quickly. However and unless stated otherwise, ground may be considered a power source having a voltage of approximately zero volts, and a power source having any desired voltage may be substituted for ground. Therefore, all gates may be powered by at least two power sources, with the attendant digital signals therefrom having voltages that range between the approximate voltages of the power sources.

Transistors are typically shown as single devices for illustrative purposes. However, it is understood by those with skill in the art that transistors will have various sizes (e.g., gate width and length) and characteristics (*e.g*., threshold voltage, gain, *etc.*) and may consist of multiple transistors coupled in parallel to get desired electrical characteristics from the combination. Further, the illustrated transistors may be composite transistors.

As used in this specification and claims, the term "channel node" refers generically to either the source or drain of a field-effect transistor (FET) device, the term "channel" refers to the path through the device between the source and the drain, and the term "control node" refers to the gate of the device. Similarly, the terms "source," "drain," and "gate" should be understood to refer respectively either to the source, drain, and gate of a FET device or to the emitter, collector, and base of a bi-polar device if an embodiment of the disclosure is implemented using bi-polar transistor technology, and vice versa.

In this specification including any claims, the term "each" may be used to refer to one or more specified characteristics of a plurality of previously recited elements or steps. When used with the open-ended term "comprising," the recitation of the term "each" does not exclude additional, unrecited elements or steps. Thus, it will be understood that an apparatus may have additional, unrecited elements and a method may have additional, unrecited steps, where the additional, unrecited elements or steps do not have the one or more specified characteristics.

As used herein, "at least one of the following: <a list of two or more elements>" and "at least one of <a list of two or more elements>" and similar wording, where the list of two or more elements are joined by "and" or "or", mean at least any one of the elements, or at least any two or more of the elements, or at least all the elements. For example, the phrases "at least one of A and B" and "at least one of A or B" are both to be interpreted to have the same meaning, encompassing the following three possibilities: 1- only A; 2- only B; 3- both A and B.

All documents mentioned herein are hereby incorporated by reference in their entirety or alternatively to provide the disclosure for which they were specifically relied upon.

The embodiments covered by the claims in this application are limited to embodiments that (1) are enabled by this specification and (2) correspond to statutory subject matter. Non-enabled embodiments and embodiments that correspond to non-statutory subject matter are explicitly disclaimed even if they fall within the scope of the claims.

As used herein and in the claims, the term "provide" with respect to an apparatus or with respect to a system, device, or component encompasses designing or fabricating the apparatus, system, device, or component; causing the apparatus, system, device, or component to be designed or fabricated; and/or obtaining the apparatus, system, device, or component by purchase, lease, rental, or other contractual arrangement.

While preferred embodiments of the disclosure have been shown and described herein, it will be obvious to those skilled in the art that such embodiments are provided by way of example only. Numerous variations, changes, and substitutions will now occur to those skilled in the art without departing from the disclosure. It should be understood that various alternatives to the embodiments of the disclosure described herein may be employed in practicing the technology of the disclosure. It is intended that the following claims define the scope of the invention and that methods and structures within the scope of these claims and their equivalents be covered thereby.

## Claims

1. An article of manufacture comprising a switchable transconductance amplifier comprising:
capacitor circuitry;
voltage-input circuitry;
selector circuitry; and
current-sink circuitry, wherein:
the voltage-input circuitry and the selector circuitry are connected between the capacitor circuitry and the current-sink circuitry;
the capacitor circuitry and the selector circuitry are configured to be controlled to selectively convert an input voltage signal applied to the voltage-input circuitry into an output current signal; and
the voltage-input circuitry and the selector circuitry are implemented at the same circuit level.

2. The article of claim 1, wherein:
the voltage-input circuitry is configured to receive at least one differential input voltage signal; and
the amplifier is configured to generate at least one differential output current signal.

3. The article of claim 2, wherein the amplifier is an N:1 multiplexer configured to receive N differential input voltage signals and generate one differential output current signal.

4. The article of claim 3, wherein the amplifier comprises:
a single instance of the capacitor circuitry; and
for each of the N differential input voltage signals:
a single instance of the voltage-input circuitry;
a single instance of the selector circuitry; and
a single instance of the current-sink circuitry, wherein the N instances of the voltage-input circuitry and the N instances of the selector circuitry are all at the same circuit level.

5. The article of claim 2, wherein the amplifier is a 1:N demultiplexer configured to receive one differential input voltage signal and generate N differential output current signals.

6. The article of claim 5, wherein the amplifier comprises, for each of the N differential output current signals:
a single instance of the capacitor circuitry;
a single instance of the voltage-input circuitry;
a single instance of the selector circuitry; and
a single instance of the current-sink circuitry, wherein the N instances of the voltage-input circuitry and the N instances of the selector circuitry are all at the same circuit level.

7. The article of claim 2, wherein the capacitor circuitry comprises a pair of capacitors connected to a pair of reset switches.

8. The article of claim 2, wherein, for each differential input voltage:
the voltage-input circuitry comprises a pair of input transistors; and
the selector circuitry comprises a single selection switch.

9. The article of claim 2, wherein the current-sink circuitry comprises a constant-current sink.
